# DEMANDE DE BREVET EUROPEEN

(11) **EP 3 327 173 A1**
(43) Date de publication de la demande: **30.05.2018**
(21) Numéro de dépôt: 17306637.4
(22) Date de dépôt: 24.11.2017
(51) Int. Cl.: C23C 16/40, C23C 16/455, C23C 16/46

(54) **PROCÉDÉ DE DÉPÔT DE COUCHE DE CHALCOGÉNURE SUR UN SUBSTRAT**

(30) Priorité: 29.11.2016 FR 1661661
(71) Demandeur: Total SA, 92400 Courbevoie (FR); Electricité de France, 75008 Paris (FR); Ecole Polytechnique, 91120 Palaiseau (FR); CENTRE NATIONAL DE LA RECHERCHE SCIENTIFIQUE, 75016 Paris (FR); Institut Photovoltaïque d'Ile de France - IPVF, 92160 Antony (FR); L'Air Liquide Société Anonyme pour l'Etude et l'Exploitation des Procédés Georges Claude, 75007 Paris (FR)
(72) Inventeur: LEBRETON, Fabien, 91140 Villebon sur Yvette (FR); ZAUNER, Andreas, 78960 VOISINS LE BRETONNEUX (FR)
(74) Mandataire: Jacobacci Coralis Harle

(57) **Abrégé**

L'invention concerne un procédé de dépôt de couche atomique de chalcogénure sur un substrat. Le substrat est successivement exposé à un premier précurseur en phase vapeur comprenant un élément métallique et à un second précurseur en phase vapeur comprenant un élément oxydant, de manière à former une monocouche monomoléculaire de chalcogénure à partir desdits premier et second précurseurs. Selon l'invention, lors des étapes de dépôt des précurseurs sur le substrat, la température du substrat reste inférieure à 300°C et/ou la température varie à une vitesse non nulle dont la valeur absolue est inférieure à 100° C.min⁻¹. Ainsi, de façon avantageuse, l'invention permet de recouvrir la surface d'un substrat avec une couche de chalcogénure formant une couche de passivation de très bonne qualité, sans qu'il soit pour cela nécessaire de recuire la couche après dépôt. La gestion/évacuation des impuretés étant partiellement réalisée durant le dépôt, l'invention limite l'apparition de cloquage au sein des films déposés.

## Description

### DOMAINE TECHNIQUE AUQUEL SE RAPPORTE L'INVENTION

La présente invention concerne le domaine de la microélectronique et du photovoltaïque, et plus particulièrement les procédés de dépôt de couches atomiques permettant de déposer une couche de chalcogénure sur une surface d'un substrat.

### ARRIERE-PLAN TECHNOLOGIQUE

Depuis plusieurs décennies, les cellules photovoltaïques sont utilisées pour produire de l'énergie électrique à partir de l'énergie solaire. L'énergie solaire offre l'avantage d'être renouvelable et inépuisable. Néanmoins, la démocratisation de l'énergie photovoltaïque est limitée par le coût de fabrication des cellules photovoltaïques. La réduction des coûts de production est donc devenue un enjeu majeur pour permettre à un plus grand nombre d'accéder à cette source d'énergie propre.

Pour cela, plusieurs procédés de fabrication ont été développés pour réduire l'épaisseur des couches constituant une cellule photovoltaïque, afin de diminuer la quantité de matière nécessaire à sa fabrication. Plus particulièrement, les tranches de silicium, utilisées comme jonction PN dans les cellules photovoltaïques, sont ainsi devenues de plus en plus fines afin de minimiser l'impact de la volatilité du prix du silicium dans le coût de fabrication d'une cellule photovoltaïque.

Néanmoins, en diminuant l'épaisseur d'une tranche de silicium, le ratio surface/volume de la couche augmente rendant les phénomènes de surfaces plus importants. Or, les performances d'une cellule photovoltaïque dépendent notamment de la vitesse de recombinaison des porteurs de charge libre au niveau de ses surfaces. De ce fait, pour préserver les rendements des couches de silicium, il est nécessaire d'apporter une attention toute particulière à la passivation de ses surfaces, cela est d'autant plus critique lorsqu'on diminue leur épaisseur.

Parmi les différents matériaux étudiés, notamment les chalcogènes, l'alumine (Al₂O₃) a montré des propriétés remarquables pour passiver la surface d'un substrat de silicium.

La technique de dépôt de couches atomiques, également connue en anglais sous le nom « Atomic Layer Déposition » (ALD), est particulièrement adaptée aux dépôts d'épaisseur uniforme et conformes sur des substrats présentant de fort ratio d'aspect. En effet, la technique ALD permet de contrôler précisément la composition ainsi que l'épaisseur de la couche déposée. Plusieurs études ont ainsi démontré que l'on peut déposer une couche d'alumine sur un substrat de silicium à basse température, c'est-à-dire inférieure à 400°C, en contrôlant précisément l'épaisseur de la couche à l'échelle nanométrique ou sub-nanométrique. Il a ainsi été possible de déposer des couches uniformes dont l'épaisseur est comprise entre quelques nanomètres et quelques centaines de nanomètres.

Néanmoins, il s'est avéré nécessaire de procéder à une étape dite de « d'activation de la passivation » de la couche d'alumine après son dépôt, consistant à traiter thermiquement ladite couche, pour obtenir une couche de passivation de bonne qualité. Pour cela, la température du traitement thermique doit être supérieure à la température du dépôt et durer plusieurs minutes. Cette étape de recuit a pour inconvénient d'exposer le substrat à une température plus haute que celle du dépôt, température susceptible de modifier les caractéristiques structurelles du substrat, en particulier au niveau de sa surface. Selon un autre inconvénient, l'étape de recuit augmente de manière significative le temps de fabrication d'une cellule photovoltaïque.

La présente invention vise donc à résoudre ces problématiques, en proposant un procédé de dépôt de couches atomiques de chalcogénure sur un substrat, moins susceptible de modifier les propriétés du substrat lors des étapes de dépôt. L'invention vise également à présenter un procédé de dépôt de couches atomiques permettant l'obtention de couches atomiques dont les propriétés physico-chimiques sont plus stables lorsque la couche de chalcogénure subit un traitement thermique après son dépôt. Plus particulièrement, l'invention souhaite proposer une méthode de passivation de la surface d'un substrat de silicium, mettant en oeuvre une technique de dépôt de couches atomiques, permettant de réduire les étapes de fabrication d'une cellule photovoltaïque à haut rendement, de sorte à réduire son coût de production.

### OBJET DE L'INVENTION

Afin de remédier à l'inconvénient précité de l'état de la technique, la présente invention propose un procédé de dépôt de chalcogénure sur un substrat, plus précisément par un procédé de dépôt de couche atomique également connu sous le nom anglais de « Atomic Layer Déposition ou ALD », comprenant les étapes suivantes :
- exposition du substrat à un premier précurseur en phase vapeur comprenant un élément métallique ou, respectivement, un élément chalcogène, de manière à chimisorber une fraction du premier précurseur sur au moins une surface du substrat pour former une monocouche monomoléculaire partielle et ce jusqu'à saturation de la surface ;
- exposition de la monocouche monomoléculaire partielle à un second précurseur en phase vapeur comprenant un élément chalcogène lorsque le premier précurseur comprend un élément métallique ou, respectivement, un élément métallique lorsque le premier précurseur comprend un élément chalcogène, de manière chimisorber une fraction de second précurseur sur la monocouche monomoléculaire partielle pour former une monocouche monomoléculaire de chalcogénure à partir desdits premier et second précurseurs.

L'invention se caractérise en ce que la surface du substrat recouverte par la fraction du premier et/ou du second précurseur, lors d'au moins une étape d'exposition, présente une température restant inférieure à 350°C et une variation de température en fonction du temps variant à une vitesse non nulle, la vitesse de variation de température ayant une valeur absolue inférieure à 100°C.min⁻¹.

Par le terme « chalcogénure », on entend un élément comprenant au moins un élément appartenant au groupe 16 ou à la colonne 16 du tableau périodique des éléments. De préférence, la couche chalcogène obtenue après dépôt comprend au moins l'un des éléments suivants : oxygène (O), soufre (S), séléniure (Se) et/ou tellure (Te).

Par le terme « chimisorber », on entend le fait de réaliser une « chimisorption » entre un premier composé chimique et un second composé chimique, permettant de combiner une partie des composés chimiques entre eux par un phénomène d'absorption via des interactions chimiques.

La réactivité des précurseurs dépend de leur température. Autrement dit, à une température de dépôt donnée, on obtient une monocouche de précurseurs dont le taux d'impureté est défini. En contrôlant le taux d'impureté, on contrôle également la densité de la monocouche. De façon avantageuse, l'invention propose de faire varier la température pour chaque dépôt de précurseur, de manière à obtenir un dépôt de monocouche atomique dont le taux de pureté et la densité varient en fonction de l'épaisseur de la couche de chalcogénure. Une élévation de la température pendant le recouvrement d'une monocouche de chalcogène, par une ou plusieurs monocouches de même nature, favorise ainsi une expulsion des sous-produits volatils des réactions entre groupement d'impuretés contenus dans les couches déjà déposées. Ainsi, de façon avantageuse, l'invention permet d'éviter une expulsion brutale et massive des sous-produits volatils lors d'un recuit post-dépôt de la couche de chalcogénure, susceptible de déformer sa surface par un phénomène de « cloquage ».

L'invention propose également un procédé de dépôt permettant d'obtenir une couche de chalcogénure dont les propriétés chimiques de réactivité et les propriétés physiques de densité ne sont pas les mêmes au niveau de leurs plus grandes faces. En effet, la première couche atomique déposée sur le substrat présente ainsi une réactivité chimique et une teneur en impureté différente par rapport à la dernière couche atomique déposée sur le substrat. De ce fait, l'invention permet la formation d'une couche de chalcogénure dont les propriétés chimiques et les propriétés physiques peuvent être adaptées en fonction du substrat qu'elle recouvre ainsi que de son environnement. Par le terme « environnement », on entend un milieu en contact avec la couche de chalcogénure, autre que le substrat. Autrement dit, l'invention permet de déposer des couches de chalcogénure dont les propriétés chimiques et physiques peuvent être adaptées au niveau de chacune de ses plus grandes faces ainsi que dans son épaisseur, en fonction de la nature du substrat et de son environnement. On peut de la sorte contrôler la qualité des interfaces entre la couche de chalcogénure déposée sur le substrat et son environnement, afin de favoriser ou non des interactions au niveau desdites interfaces.

Selon un autre avantage de l'invention, le procédé de dépôt est réalisé à des températures relativement basses, c'est-à-dire, en dessous de 350°C de préférence en dessous de 300°C ou 100°C, afin de limiter l'impact du traitement thermique sur les propriétés chimiques et structurelles du substrat.

Selon une autre caractéristique de l'invention, le substrat est transvasé entre deux zones distinctes de dépôt, entre deux étapes successives d'exposition, afin d'être exposé à un précurseur différent dans chaque zone de dépôt. Eventuellement, les zones distinctes de dépôt peuvent être comprises dans une même chambre de dépôt ou bien réparties dans plusieurs chambres de dépôt.

Selon une autre caractéristique de l'invention, entre deux étapes d'expositions successives, un précurseur non déposé et des sous-produits volatils de réaction de chimisorption sont évacués d'une chambre de dépôt. Ce mode de réalisation est particulièrement adapté pour mettre en oeuvre une technique de dépôt de couche atomique temporelle, dans une unique chambre de dépôt.

Selon une autre caractéristique de l'invention, au niveau de la surface du substrat recouverte par la fraction du premier et/ou du second précurseur, lors des étapes d'exposition au premier précurseur et, respectivement, au second précurseur, la variation de la température en fonction du temps est de signe constant. Ce mode de réalisation permet avantageusement d'obtenir une couche de chalcogénure dont les propriétés chimiques et physiques sont très différentes au niveau de ses plus grandes faces. En effet, plus la variation de température est importante, plus la réactivité et la densité sont différentes au niveau de la première et la dernière couche de précurseur déposée.

Selon une autre caractéristique de l'invention, au niveau de la surface du substrat recouverte par la fraction du premier et/ou du second précurseur, lors des étapes d'exposition au premier précurseur et, respectivement, au second précurseur, la variation de la température en fonction du temps est de signe négatif ou positif.

Une variation de température en fonction du temps de signe négatif permet avantageusement de former avec le substrat et la couche déposée une interface très pure dont la réactivité chimique (pureté) et la densité sont plus importantes par rapport aux couches monomoléculaire des cycles recouvrant ladite première couche. Ainsi, pour favoriser l'obtention d'une interface homogène entre le substrat et la première monocouche déposée, on choisira préalablement au dépôt une température la plus haute possible, dans les plages de valeurs mentionnées ci-dessus. Selon un autre avantage, une variation de température en fonction du temps de signe négatif permet l'obtention d'une interface de grande pureté, comprenant dans son voisinage des impuretés qui permettront par la suite de combler les éventuels défauts présents au niveau des interfaces entre les couches déposées. Par ailleurs, cela permet aussi la formation d'une monocouche en contact avec le substrat se caractérisant par une constante diélectrique de valeur élevée due à l'absence d'impureté au niveau de l'interface substrat/première monocouche, ce qui est avantageux pour la réalisation de dispositifs microélectroniques.

À l'inverse, une variation de température en fonction du temps de signe positif privilégie moins d'interactions et donc plus d'impuretés entre la première monocouche déposée et le substrat.

Les étapes successives d'exposition du substrat au premier et au second précurseur définissent un cycle de dépôt d'une monocouche monomoléculaire de chalcogénure. Le procédé de dépôt selon l'invention peut effectuer un ou plusieurs cycles de dépôt successifs de manière à former sur le substrat une couche de chalcogénure dont l'épaisseur est comprise entre 0.1nm et 500nm. De préférence, afin de limiter un phénomène d'absorption et/ou d'interférence de la lumière traversant la couche de chalcogénure, susceptible de donner à ladite couche un aspect de couche antireflet, son épaisseur est égale ou inférieure à 150nm. À titre d'exemple, la couche de chalcogénure peut être comprise entre 150nm et 2nm ou entre 100nm et 2nm ou entre 10nm et 2nm.

Selon une autre caractéristique de l'invention, les étapes d'exposition sont répétées cycliquement d'une première à une dernière étape jusqu'à obtenir une couche de chalcogénure d'épaisseur souhaitée, et en ce qu'au niveau de la surface du substrat recouverte par le premier et/ou le second précurseur, de la première à la dernière étape d'exposition du procédé de dépôt, la variation de la température en fonction du temps est de signe constant.

Selon une autre caractéristique de l'invention, au niveau de la surface du substrat recouverte par la fraction du premier et/ou du second précurseur, d'une première à une dernière étape d'exposition du procédé de dépôt, la valeur absolue de la variation de température est supérieure à 10°C, de préférence supérieure à 50°C. Comme mentionné ci-dessus, plus la variation de température est importante, plus on différencie les propriétés chimiques et physiques des monocouches monomoléculaires déposées et formant la couche de chalcogène. On peut ainsi choisir de rendre plus ou moins sensible une grande face de la couche de chalcogénure à son milieu. On permet également de densifier les couches déjà déposées en favorisant l'expulsion d'une plus grande quantité de sous-produits volatils des réactions de chimisorption au cours du ou des cycles de dépôt.

Selon une autre caractéristique de l'invention, au niveau de la surface du substrat recouverte par la fraction du premier et/ou du second précurseur, d'une première à une dernière étape d'exposition du procédé de dépôt, la valeur absolue de la variation de température est inférieure à 200°C. À l'inverse, plus la variation de température est réduite, moins on différencie les propriétés chimiques et physiques des plus grandes faces de la couche de chalcogénure et moins on fait varier les propriétés physiques et chimiques des monocouches précédemment déposées. On peut alors former une couche de chalcogénure dont les plus grandes faces interagissent sensiblement de la même façon avec leur milieu.

Selon une autre caractéristique de l'invention, au niveau de la surface du substrat recouverte par le premier et le second précurseur, de la première à la dernière étape d'exposition du procédé de dépôt, la valeur absolue de la vitesse de variation de température est supérieure à 1° C.min⁻¹, de préférence supérieure à 50° C.min⁻¹.

Selon une autre caractéristique de l'invention, la vitesse de variation absolue de température au niveau de la surface du substrat recouverte par la fraction du premier et/ou du second précurseur, d'une étape d'exposition à l'étape suivante, est comprise entre 0,33°C et 5°C, de préférence entre 0,5°C et 2,5°C.

Selon une autre caractéristique de l'invention au niveau de la surface du substrat recouverte par le premier et le second précurseur, de la première à la dernière étape d'exposition du procédé de dépôt, la température varie selon un profil comprenant au moins une partie linéaire et/ou au moins un point d'inflexion et/ou au moins une partie de forme exponentielle et/ou au moins une partie de forme logarithmique. En fonction du profil de variation de la température, on peut varier les propriétés physiques et chimiques de la couche de chalcogénure déposée, en fonction de son épaisseur. Ainsi, on peut par exemple faire varier rapidement ces propriétés au niveau d'au moins une plus grande face de la couche, afin de limiter les phénomènes d'interaction avec son milieu au niveau de ladite face.

Selon une autre caractéristique de l'invention, l'un des précurseurs comprend au moins l'un des éléments suivants : oxygène (O), soufre (S), sélénium (Se), tellure (Te).

Selon une autre caractéristique de l'invention, l'un des précurseurs comprend au moins un élément à caractère métallique et l'autre précurseur comprend de l'hydrogène et de l'oxygène, de manière à former une couche d'oxyde métallique. Selon un mode de réalisation particulier, la monocouche monomoléculaire de chalcogénure comprend au moins l'une des compositions suivantes : Li₂O, B₂O₃, MgO, AlLaO₃, AlPrₓO_{y}, AlNdₓO_{y}, AlₓSi_{y}O_{z}, SiO₂, POₓ, CaO, Sc₂O₃, TiO₂, VOₓ, CrOₓ, MnOₓ, FeOₓ, COₓ, NiO, CuOₓ, ZnO, Ga₂O₃, GeO₂, SrO, Y₂O₃, ZrO₂, Nb₂O₅, In₂O₃, SnO₂, Sb₂O₅, BaO, BaB₂O₄, La₂O₃, LaAlO₃, PrOₓ, PrAlₓO_{y}, NdAlₓO_{y}, Gd₂O₃, Er₂O₃, Lu₂O₃, LuSiₓO_{y}, HfO₂, Ta₂O₅, WOₓ, PbO₂, BiOₓ. Selon un autre mode de réalisation particulier, le second précurseur comprend de l'eau ou H₂O₂ et/ou de l'alcool.

Selon une autre caractéristique de l'invention, l'un des précurseurs est à base de triméthylaluminium et l'autre précurseur est à base de molécules d'eau, de manière à former une couche d'oxyde d'aluminium sur une surface du substrat.

Selon une autre caractéristique de l'invention, le substrat est un substrat couramment utilisé dans l'industrie du photovoltaïque pour réaliser des cellules solaires. À titre d'exemple, le substrat peut par exemple être réalisé à partir d'au moins un des éléments suivants : Si, Ga, N, As, Al, N, Cu, Zn, Sn, S, In, Ga, S, Se.

La présente invention porte également sur un dispositif électronique comprenant un substrat dont au moins une partie d'une surface est recouverte par au moins une couche de chalcogénure, réalisée à partir d'un procédé de dépôt décrit ci-dessus. Selon un mode de réalisation particulier, l'épaisseur de couche de chalcogénure déposée est comprise entre 0.1nm et 500nm, de préférence entre 2nm et 150nm.

La présente invention porte aussi sur une cellule photovoltaïque comprenant un substrat dont au moins une partie d'une surface est recouverte par au moins une couche de chalcogénure, réalisée à partir d'un procédé de dépôt décrit ci-dessus. Selon un mode de réalisation particulier, l'épaisseur de couche de chalcogénure déposée est comprise entre 0.1nm et 500nm, de préférence entre 2nm et 50nm.

### DESCRIPTION DETAILLEE DES FIGURES

La description qui va suivre en regard de la figure annexée, donnée à titre d'exemple non limitatif, fera bien comprendre en quoi consiste l'invention et comment elle peut être réalisée.

Sur les dessins annexés :

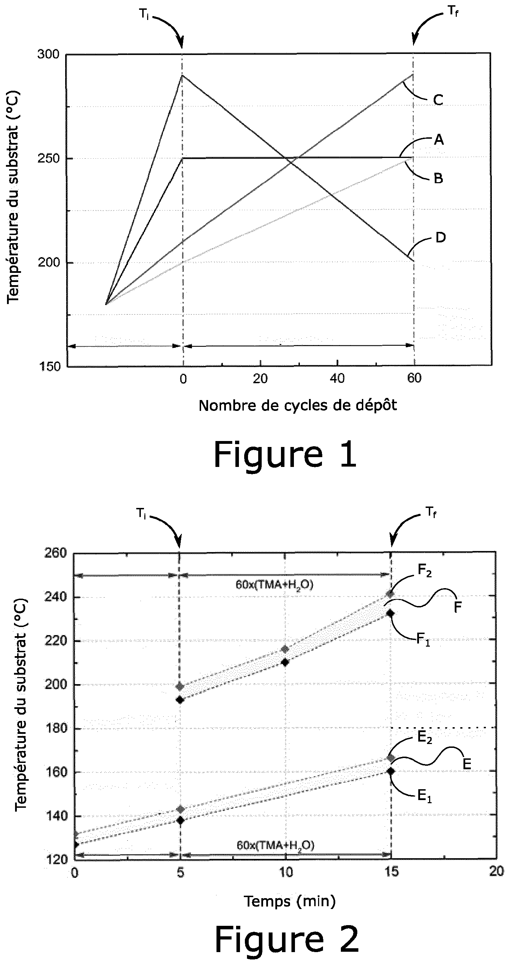

- la figure 1 représente la variation de la température au cours du temps lors du dépôt d'une couche d'alumine sur un substrat de silicium par une technique ALD classique (A), c'est-à-dire, à température constante et par des techniques ALD selon l'invention durant laquelle la température (B, C, D) du substrat varie lors du dépôt de la couche d'alumine ;
- la figure 2 représente la variation de la température au niveau du substrat au cours du temps, lors du dépôt d'une couche d'alumine sur un substrat de silicium par une technique ALD selon l'invention, durant laquelle la température (E, F) du substrat augmente lors du dépôt de la couche d'alumine ;

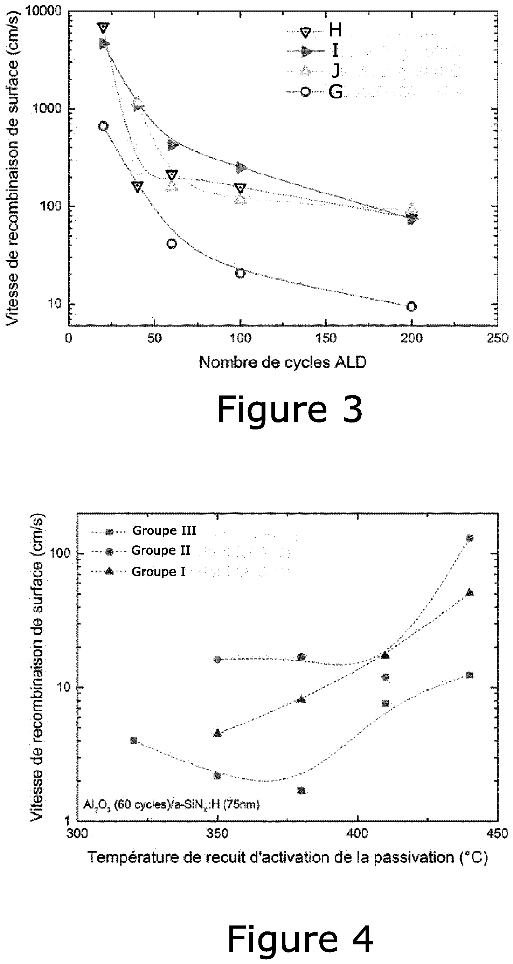

- la figure 3 représente des estimations de la vitesse de recombinaison de surface (SRV) des porteurs de charges minoritaires à la surface d'un substrat recouvert par une couche d'alumine déposée par une technique ALD classique, c'est-à-dire, à température constante, respectivement 200°C, 250°C et 300°C pour les courbes (H), (I) et (J), et une technique ALD selon l'invention (G) durant laquelle la température du substrat augmente de 200°C à 250°C lors du dépôt de la couche d'alumine ;
- la figure 4 représente des estimations de la SRV pour différents groupes (I, II, III) de substrats de silicium recouverts par une couche d'alumine selon les procédés de l'état de la technique (groupes I et II) et selon un procédé de l'invention (groupe III), après recuit à différentes températures puis encapsulation par le même nitrure de silicium amorphe.

### DESCRIPTION DETAILLEE D'UN EXEMPLE DE REALISATION

Pour rappel, l'invention vise proposer un procédé de dépôt de couches atomiques de chalcogénure sur un substrat, moins susceptible de modifier les propriétés du substrat lors des étapes de dépôt. L'invention vise également à présenter un procédé de dépôt de couches atomiques permettant l'obtention de couches atomiques dont les propriétés physico-chimiques sont plus stables lorsque la couche de chalcogénure subit un traitement thermique après son dépôt. Plus particulièrement, l'invention souhaite proposer une méthode de passivation de la surface d'un substrat de silicium, mettant en oeuvre une technique de dépôt de couches atomiques, permettant de réduire les étapes de fabrication d'une cellule photovoltaïque à haut rendement, de sorte à réduire son coût de production.

Selon un exemple de réalisation non limitatif de l'invention, le procédé est mis en oeuvre pour former une couche d'alumine (Al₂O₃) à la surface d'un substrat de silicium (Si) par une technique dite « temporelle ». Pour cela, une première étape du procédé consiste à placer le substrat de silicium dans une chambre de dépôt sous vide d'un réacteur de type « R-200 » commercialisé sous la marque « PICOSUN ». Plus précisément, le substrat est placé sur une platine chauffante dont la température peut être contrôlée et modifiée précisément au cours du temps à l'aide d'un module de contrôle dédié, afin de faire varier la température du substrat au cours du temps comme expliqué ci-dessous. Bien entendu, d'autres méthodes sont envisageables pour faire varier la température du substrat lors du procédé. A titre d'exemple, on peut utiliser des portes-substrats de masses thermiques différentes, afin de contrôler la variation plus ou moins rapide de la température du substrat lorsque l'ensemble porte-substrat et échantillon est introduit à l'intérieur de la chambre où la température est constante.

Selon le présent exemple, durant les différentes étapes de dépôt décrites ci-dessous, la chambre est maintenue à une pression de l'ordre de 9 hPa (hecto-Pascal).

Selon une deuxième étape, un premier précurseur comprenant du triméthylaluminium Al₂(CH₃)₆ en phase vapeur est introduit dans la chambre et entraîné vers le substrat par un gaz inerte de type argon ou azote par exemple. Le substrat est exposé durant un temps suffisant pour permettre au triméthylaluminium ou TMA, de se chimisorber avec au moins une surface du substrat. Le temps d'exposition du substrat au TMA dépend de plusieurs paramètres, notamment de la surface du substrat que l'on souhaite recouvrir, de la pression régnant dans la chambre et de la concentration de TMA en phase vapeur. Selon le présent exemple, le substrat est exposé pendant 0,1s au TMA. Néanmoins, l'homme du métier saura ajuster les paramètres nécessaires selon les méthodes conventionnelles de dépôt par ALD pour obtenir une fraction de TMA ayant réagi avec la surface d'au moins une surface du substrat de silicium.

Selon une troisième étape, on réalise une purge de la chambre de dépôt pendant 4s avec un gaz inerte (argon ou azote par exemple) afin d'évacuer le TMA ainsi que les produits volatils de la réaction chimique entre le TMA et les éléments présents à la surface du substrat de silicium, qui n'ont pas réagi.

Selon une quatrième étape, un second précurseur comprenant de l'eau en phase vapeur est introduit dans la chambre et entraîné vers le substrat par un gaz inerte de type argon ou azote par exemple. Le substrat est exposé durant un temps suffisant pour permettre à l'eau de se lier avec la couche de TMA précédemment déposée, afin de réagir chimiquement avec une fraction de TMA pour former une couche monomoléculaire d'alumine (Al₂O₃). Selon le présent exemple, le TMA est exposé pendant 0,1s au second précurseur. De même que ci-dessus, l'homme du métier saura ajuster les paramètres nécessaires selon les méthodes conventionnelles de dépôt par ALD pour que la couche monomoléculaire de fraction de TMA ayant réagi avec le substrat de silicium soit recouverte par des groupements OH provenant des molécules d'eau.

Selon une cinquième étape, on réalise de nouveau une purge de la chambre de dépôt pendant 6s, de manière à évacuer avec un gaz inerte (argon ou azote par exemple) l'eau dans la chambre ainsi que les produits volatils de la réaction chimique entre l'eau et les éléments présents à la surface la couche monomoléculaire de fraction de TMA, qui n'ont pas réagi.

Les étapes deux à cinq sont réitérées jusqu'à l'obtention d'une couche d'oxyde d'aluminium à la surface du substrat ayant l'épaisseur souhaitée.

Il est à noter que l'invention peut également être mise en oeuvre par une technique de dépôt de couche atomique dite « spatiale ». Cette technique se distingue de la précédente en ce que le substrat est transvasé entre au moins deux zones distinctes de dépôt, dans lesquelles le substrat est exposé à l'un ou l'autre des précurseurs. Cette méthode permet avantageusement de s'affranchir des étapes de purge décrites ci-dessus en les remplaçants par un rideau de gaz neutre qui est traversé lors du passage d'une zone à une autre. Les conditions de dépôt pour chacun des précurseurs peuvent être identiques ou bien différentes des paramètres de dépôt mentionnés ci-dessus.

La technique de dépôt par ALD spatiale ou temporelle selon l'invention, se distingue des techniques de dépôt par ALD connues, en ce que durant les étapes d'interactions physico-chimiques des précurseurs sur le substrat, la température du substrat est modifiée au cours du temps par l'inertie thermique du porte-échantillon ou par l'intermédiaire de la platine chauffante, afin de modifier la réactivité des précurseurs lors de la formation de chaque couche déposée. Comme le montre la figure 1, le dépôt d'une couche d'alumine sur un substrat de silicium par une technique de dépôt par ALD classique, consiste à préchauffer le substrat jusqu'à une température de dépôt correspondant dans le cas présent à 250°C (voir courbe A), puis effectuer plusieurs cycles de dépôt de couches d'alumine en maintenant la température à 250°C jusqu'au dépôt de la dernière couche. L'invention propose une nouvelle technique de dépôt par ALD consistant à préchauffer le substrat à une température initiale (Tᵢ) puis faire varier la température du substrat pendant le dépôt des couches d'alumine sur le substrat, jusqu'à une température finale (T_{f}).

La température initiale (Tᵢ) est comprise entre 100°C et 300°C, de préférence entre 130°C et 200°C. La température finale est inférieure à 350°C, de préférence inférieure à 300°C. La valeur absolue de l'écart de températures entre la température finale et la température initiale est comprise entre 10% et 150%, de préférence entre 30% et 70% de la température initiale. La vitesse de variation de la température dépend bien évidemment du nombre de couches déposées, de sorte que la valeur absolue de la variation de la température peut être comprise entre 1° C.min⁻¹ et 100° C.min⁻¹, de préférence entre 30° C.min⁻¹ et 80° C.min⁻¹. À titre d'exemple, la variation de température peut être comprise entre 0,33°C et 5°C par cycle de dépôt, de préférence entre 0,5°C et 2,5°C par cycle de dépôt. Par le terme « cycle », on entend ici l'exposition successive du substrat au premier et au second précurseur.

La figure 1 montre plusieurs exemples de variation de température au cours des cycles de dépôt d'une couche d'alumine sur un substrat de silicium. Plus précisément, la courbe B correspond à une augmentation de la température de 200°C à 250°C et la courbe C à une augmentation de la température entre 210°C et 290°C pendant 60 cycles de dépôt de couches d'alumine. La courbe D correspond à une diminution de la température de 290°C à 200°C pendant le même nombre des cycles de dépôt. Il est à noter que les températures varient de façon linéaire pendant tous les cycles de dépôt, néanmoins l'invention ne se limite pas à ces seuls profils de température au cours du temps. L'homme du métier est apte à choisir d'autres profils de température permettant de faire varier toujours dans le même sens la température lors du dépôt entre une température initiale (Tᵢ) et une température finale (T_{f}).

Selon un autre exemple de mise en oeuvre de l'invention représenté à la figure 2, la température d'un substrat de silicium est augmentée au cours de 60 cycles de dépôt d'une couche d'alumine sur une de ses faces, pendant 10 minutes. Plus précisément, selon un premier exemple illustré par la courbe E, la température augmente de façon linéaire entre une température initiale (Tᵢ) de l'ordre de 140°C et une température finale (T_{f}) de l'ordre de 160°C, la température réelle étant comprise entre les courbes E₁ et E₂. Selon un deuxième exemple illustré par la courbe F, la température augmente de façon linéaire entre une température initiale (Tᵢ) de l'ordre de 200°C et une température finale (T_{f}) de l'ordre de 240°C, la température réelle étant comprise entre les courbes F₁ et F₂. Pour chaque exemple, les mêmes conditions de dépôt ont été reproduites selon des conditions classiques de dépôt par ALD, c'est-à-dire, en maintenant la température initiale constante lors du dépôt. Des mesures de temps de vie des porteurs de charges minoritaires ont permis d'estimer la SRV pour chaque substrat ont ensuite été réalisées après dépôt de la couche d'alumine. Lorsque la température initiale est de l'ordre de 200°C, la valeur de SRV est de l'ordre de 400 cm.s⁻¹ pour une technique de dépôt classique par ALD et de l'ordre 150 cm.s⁻¹ pour une technique de dépôt par ALD selon l'invention. Lorsque la température initiale est de l'ordre de 200°C, la valeur de SRV est de l'ordre de 250 cm.s⁻¹ pour un dépôt par une technique classique de dépôt par ALD et de l'ordre de 40 cm.s⁻¹ pour une technique de dépôt par ALD selon l'invention.

Ainsi, en modifiant de façon continue la température entre la température initiale (Tᵢ) et la température finale (T_{f}), les inventeurs ont observé de façon surprenante qu'il est possible de modifier la vitesse de recombinaison des charges libres de surface (SRV) au niveau de la surface du silicium recouverte par la couche d'alumine sans qu'il soit pour cela nécessaire de recuire la couche d'alumine après son dépôt.

En augmentant régulièrement la température, les inventeurs sont notamment parvenus à obtenir des valeurs de SRV à la surface de substrat de silicium bien inférieures par rapport à celles obtenues sans variation de la température. Plus précisément, comme illustrée à la figure 3, la valeur estimée de SRV de la courbe G diminue fortement entre 50 et 200 cycles de dépôts pour un substrat recouvert selon un procédé décrit ci-dessus, pendant lequel la température au niveau du substrat est progressivement augmentée de 190°C jusqu'à 250°C de façon sensiblement constante (10 cycles de dépôt correspondant au dépôt d'une couche d'épaisseur de 1 nm).

Or, dans les mêmes conditions de dépôt, sans variation de la température initiale, les courbes H, I et J de la figure 3 correspondant à un dépôt effectué respectivement à une température constante 200°C, 250°C et 300°C, montrent que la valeur de SRV reste sensiblement constante à partir de 100 cycles de dépôt et que l'invention permet de diminuer d'un facteur 10 la SRV à partir de 200 cycles de dépôt, en augmentant progressivement et continuellement la température du substrat. Pour atteindre ces valeurs, il était jusqu'à présent nécessaire de procéder à un recuit de la couche d'alumine déposée, à une température supérieure à la température initiale de dépôt, de l'ordre de 400°C. Grâce à l'invention, cette étape de recuit n'est plus nécessaire ce qui permet avantageusement de préserver les propriétés du substrat.

Selon les inventeurs, outre le changement de composition du matériau en cours de dépôt à l'instant t où varie la température, le matériau déjà déposé à l'instant t-1 voit sa température augmenter et ainsi certains groupements chimiques voient leurs probabilités de réaction augmenter, les groupements Al-OH ou Si-OH selon le présent exemple. En réagissant entre eux au sein du matériau déjà déposé plutôt qu'avec les réactifs arrivants à la surface du matériau en cours de dépôt, ces groupements chimiques libèrent des espèces chimiques différentes comme le dihydrogène ou l'oxygène. Le dihydrogène est alors apte à diffuser hors de la couche déposée ou bien vers l'interface c-Si/Al₂O₃ où il passive les liaisons pendantes restantes du silicium. L'oxygène atomique quant à lui reste piégé dans la couche déposée et à tendance à oxyder l'interface c-Si/Al₂O₃, soit en trouvant des laissons pendantes, soient en brisant des liaisons faibles au niveau de la surface du substrat. Ainsi, en augmentant la température lors des étapes de dépôt permet de concentrer l'oxygène et le dihydrogène contenus dans les couches déposées, à proximité de l'interface c-Si/Al₂O₃ ce qui favorise une meilleure passivation de la surface du silicium. Autrement dit, plus l'augmentation de température est élevée, plus on obtient des taux de passivation élevés après dépôt sans qu'il soit pour cela nécessaire de procéder à un recuit à plus haute température.

Ainsi, l'invention permet le dépôt de couche d'alumine de faible épaisseur, par exemple inférieure à 30 nm, formant une couche de passivation de très bonne qualité à la surface d'un substrat de silicium, sans qu'il soit pour cela nécessaire de procéder à un recuit de la couche à plus haute température. Le substrat de silicium peut ainsi être utilisé pour la fabrication de cellules photovoltaïques à haut rendement pour un coût de fabrication moindre.

À présent, la figure 4 reporte l'estimation des SRV de substrats de silicium recouverts par une couche d'alumine, après des recuits de 30 minutes à 350°C, 380°C, 410°C ou 440°C. Chaque substrat est préparé dans les mêmes conditions, par un trempage dans un bain d'acide fluorhydrique (5%) pendant 30s, puis un séchage à l'azote. Un premier groupe (I) de substrat est recouvert par une couche d'alumine selon une technique classique de dépôt de couche atomique, comprenant 60 cycles de dépôt à une température constante de 250°C. Un deuxième groupe (II) de substrat est recouvert également par une couche d'alumine dans les mêmes conditions que le groupe (I) excepté le fait que la température lors du dépôt de la couche d'alumine est maintenue à 200°C. Enfin, un troisième groupe (III) de substrat est recouvert par une couche d'alumine pendant 60 cycles de dépôt pendant lesquels la température varie de 200°C à 250°C conformément à l'invention. Tous les substrats sont ensuite recouverts d'un film de a-SiN_{X}:H dont l'épaisseur est de l'ordre de 75nm, avant de subir un dernier recuit pendant 20 minutes à 380°C. La figure 4 permet de constater pour chaque température de recuit, le groupe (III) présente une valeur de SRV bien inférieure aux groupes (I) et (II). D'autre part, après recuit la couche d'alumine présente une surface plus régulière dans le groupe (III) que dans le groupe (II) où une forte densité de cloques est observable. Ainsi, l'invention permet également la réalisation de film de passivation plus performant également après recuit.

Les inventeurs ont aussi remarqué de façon surprenante qu'en réduisant la température initiale lors du dépôt des couches d'alumine par exemple représentée par la courbe D sur la figure 1, le procédé selon l'invention permet la formation de couches d'alumine épaisses qui sont moins sujettes à un phénomène de cloquage, par délamination de l'interface AlOx/c-Si, ou de boursoufflure de leur surface. Par le terme « épais », on entend des couches dont l'épaisseur est supérieure à 100nm, de préférence compris entre 100nm et 10nm. Plus précisément, il semble qu'en optant pour une température initiale (Tᵢ) supérieure à une température finale (T_{f}), on privilégie une forte réactivité entre la première couche déposée et la surface du substrat de silicium de sorte à former une interface c-Si/Al₂O₃ de très bonne qualité. Il semble que très peu de groupements de types Si-OH et Al-OH soient présents au niveau de ladite interface, groupements considérés comme des défauts électriques en microélectronique. Au fur et à mesure que la température diminue lors des cycles de dépôt, la proportion de groupements Al-OH tend ainsi à augmenter lorsque l'épaisseur du film d'alumine augmente. Il semble donc qu'une diminution de la température lors des cycles de dépôt puisse permettre de limiter l'épaisseur du SiO₂ interfacial, car, les atomes d'oxygène sont moins susceptibles de diffuser vers une zone plus dense alors que le dihydrogène semble toujours pouvoir diffuser vers les liaisons pendantes restantes à l'interface c-Si/Al₂O₃.

## Revendications

1. Procédé de dépôt de couche de chalcogénure sur un substrat, comprenant les étapes suivantes :
- exposition du substrat à un premier précurseur en phase vapeur comprenant un élément métallique ou, respectivement, un élément chalcogène, de manière à chimisorber une fraction du premier précurseur sur au moins une surface du substrat pour former une monocouche monomoléculaire partielle et ce jusqu'à saturation de la surface ;
- exposition de la monocouche monomoléculaire partielle à un second précurseur en phase vapeur comprenant un élément chalcogène lorsque le premier précurseur comprend un élément métallique ou, respectivement, un élément métallique lorsque le premier précurseur comprend un élément chalcogène, de manière chimisorber une fraction de second précurseur sur la monocouche monomoléculaire partielle pour former une monocouche monomoléculaire de chalcogénure à partir desdits premier et second précurseurs ;
**caractérisé en ce que** la surface du substrat recouverte par la fraction du premier et/ou du second précurseur, lors d'au moins une étape d'exposition, présente une température restant inférieure à 350°C et une variation de température en fonction du temps variant à une vitesse non nulle, la vitesse de variation de température ayant une valeur absolue inférieure à 100° C.min⁻¹.

2. Procédé de dépôt selon la revendication 1, dans lequel entre deux étapes d'expositions successives, un précurseur non déposé et des sous-produits volatils de réaction de chimisorption sont évacués d'une chambre de dépôt.

3. Procédé de dépôt selon la revendication 1 ou 2, dans lequel au niveau de la surface du substrat recouverte par la fraction du premier et/ou du second précurseur, lors des étapes d'exposition au premier précurseur et, respectivement, au second précurseur, la variation de la température en fonction du temps est de signe constant.

4. Procédé de dépôt selon l'une des revendications précédentes, dans lequel au niveau de la surface du substrat recouverte par la fraction du premier et/ou du second précurseur, lors des étapes d'exposition au premier précurseur et, respectivement, au second précurseur, la variation de la température en fonction du temps est de signe négatif ou positif.

5. Procédé de dépôt selon l'une des revendications précédentes, dans lequel les étapes d'exposition sont répétées cycliquement d'une première à une dernière étape jusqu'à obtenir une couche de chalcogénure d'épaisseur souhaitée, et en ce qu'au niveau de la surface du substrat recouverte par le premier et/ou le second précurseur, de la première à la dernière étape d'exposition du procédé de dépôt, la variation de la température en fonction du temps est de signe constant.

6. Procédé de dépôt selon la revendication 5, dans lequel au niveau de la surface du substrat recouverte par la fraction du premier et/ou du second précurseur, d'une première à une dernière étape d'exposition du procédé de dépôt, la valeur absolue de la variation de température est supérieure à 10°C.

7. Procédé de dépôt selon la revendication 5 ou 6, dans lequel au niveau de la surface du substrat recouverte par la fraction du premier et/ou du second précurseur, d'une première à une dernière étape d'exposition du procédé de dépôt, la valeur absolue de la variation de température est inférieure à 200°C.

8. Procédé selon l'une des revendications 5 à 7, dans lequel au niveau de la surface du substrat recouverte par le premier et le second précurseur, de la première à la dernière étape d'exposition du procédé de dépôt, la valeur absolue de la vitesse de variation de température est supérieure à 1° C.min⁻¹.

9. Procédé selon l'une des revendications 5 à 8, dans lequel la vitesse de variation absolue de température au niveau de la surface du substrat recouverte par la fraction du premier et/ou du second précurseur, d'une étape d'exposition à l'étape suivante, est comprise entre 0,33°C et 5°C.

10. Procédé de dépôt selon l'une des revendications précédentes, dans lequel l'un des précurseurs comprend au moins l'un des éléments suivants : oxygène (O), soufre (S), sélénium (Se), tellure (Te).

11. Procédé de dépôt selon l'une des revendications 1 à 9, dans lequel l'un des précurseurs comprend au moins un élément à caractère métallique et l'autre précurseur comprend de l'hydrogène et de l'oxygène, de manière à former une couche d'oxyde métallique.

12. Procédé de dépôt selon l'une des revendications précédentes, dans lequel l'un des précurseurs est à base de triméthylaluminium et l'autre précurseur est à base de molécules d'eau, de manière à former une couche d'oxyde d'aluminium sur une face du substrat.

13. Procédé de dépôt selon l'une des revendications précédentes, dans lequel le substrat est un substrat de silicium.

14. Dispositif électronique comprenant un substrat dont au moins une partie d'une surface est recouverte par au moins une couche de chalcogénure, réalisée à partir d'un procédé de dépôt selon l'une des revendications précédentes.

15. Cellule photovoltaïque comprenant un substrat dont au moins une partie d'une surface est recouverte par au moins une couche de chalcogénure, réalisée à partir d'un procédé de dépôt selon l'une des revendications 1 à 13.
